Europäisches Patentamt

(19) European Patent Office

Office européen des brevets

(11) **EP 0 793 109 A1**

(12) **EUROPEAN PATENT APPLICATION**
published in accordance with Art. 158(3) EPC

(43) Date of publication:
**03.09.1997 Bulletin 1997/36**

(51) Int. Cl.$^6$: **G01R 25/00**, G01R 25/08,
G04F 5/00, G04G 7/02

(21) Application number: **95937750.8**

(22) Date of filing: **17.11.1995**

(86) International application number:
**PCT/CN95/00092**

(87) International publication number:
**WO 96/16336 (30.05.1996 Gazette 1996/25)**

(84) Designated Contracting States:
**DE FR GB**

(30) Priority: **17.11.1994 CN 94118430**
**13.06.1995 CN 95106374**

(71) Applicant:
**NORTH CHINA UNIVERSITY OF ELECTRIC POW
ER
Baoding, Hebei 071003 (CN)**

(72) Inventor: **HAO, Yushan
Hebei 071003 (CN)**

(74) Representative: **Barlow, Roy James et al
J.A. KEMP & CO.
14, South Square
Gray's Inn
London WC1R 5LX (GB)**

(54) **MEASURING METHOD AND MEASURING SYSTEM OF PHASE ANGLE OF ELECTRICAL SYSTEM SINUSOIDAL QUANTITIES**

(57) The present invention relates to a measuring method and a system of phase angle of electrical system sinusoidal quantities, the method includes selecting a key station as a reference station, other stations desired to be measured as sub-stations in electrical system, establishing an unitized standard unit of time, and so, avoids delay in signal transference. Further, signals which are designated with standard unit of time are compared to each other, in order to find the phase angle of the signals. Otherwise, the signal of the reference station may also be transferred to the sub-stations as a reference signal. The signals which are transferred to the sub-stations are corrected and compensated for phase delay in transference, further they and the measured signals of the sub-stations are calculated in order to find the phase angle. Since the resent method is used to measure the phase angles of electrical system sinusoidal quantities, the electrical system can be measured in real time, therefore the method provides a new way to measure phase angle easily.

FIG .1

## Description

<u>Field of the invention</u>

The invention generally relates to electric power systems and theirs automation, paticularly to measuring method and system of phase angle of sinusoidal quantities in electric power systems.

<u>Background of the invention</u>

One of the most important indexes of power systems is operation safety and steady. Therefore, a lot of expensive computers and communication equipment have been invested to set up scheduling and controlling systems having functions such as remote signaling, remote telemetering, remote controlling , remote tuning and safety monitoring of electric power systems . However, as an electric power system covers vast in territory, phase angle measurements can not be attained in real-time and directly. Phase angles are computed from power flow analysis or state estimations which are based on telemetering voltages, active powers and reactive powers. This measurement method is not only inaccurate but also time consuming, impossible to be used in safety and steady analysis or emergency control in electric power systems. Monitoring of power system stability has to be based on the change of active and reactive power in networks and steady state of power system be judged indirectly.

With development of science technology, specially, of computers, communication and satellite technology, it turns vast into near in territory to make phase angle measurements possible. There are, more, microwave and optical fiber communication with high speed and great capacity , and the global position systems (GPS) having accurate location within ±15m and accurate time within ±1μs These advanced communication means and technology provide pledge for this invention.

<u>Summary of the invention</u>

The main aim of the invention is to accurately measure phase angles of voltages, currents and electric potentials of generator in real-time with adding a few of equipment in current electric power communication systems. The measurement according the invention call reach 0.1° in accurate and several times per cycle of power frequency.

Therefore , an object of the invention is to provide a precious phase angle measurement method and system by using GPS to sign time mark on signals to be broadcasted so as to prevent the signal from communication delay.

A further object of the invention is to provide a real-time precious phase angle measurement system by using GPS , computer and automation technology.

A further object of the invention is to provide a real-time phase angle precious measurement method and system by using modem automation technology to set up predicting model in order to avoid of time consumation of communication systems.

Another object of the invention is to provide a real-time precious phase angle measurement method and system by compensating phase delay in communication systems.

The invention provides a phase angle measurement method and system in electric power system. The method comprises steps of

a) at a reference station, measuring the relation between the reference signal phase and the time, determining the reference signal phase ($\phi_0$) at a series of given time, or determining the time ($t_0$) at a series of given phases;

b) sending the phase ($\phi_0$) or time ($t_0$) of the reference signal to each substation by communication;

c) at a substation, measuring the relation between a tested signal phase and the time, determining the phase of the tested signal ($\phi_m$) at the same given time as to the reference signal, or determining the time ($t_m$) at the same given phase of the tested signal as to the reference signal and storing the measurement values $\phi_m$ or $t_m$;

d) receiving the phase $\phi_0$ or time $t_0$ of the reference signal;

e) in accordance with $\phi_0$ received and $\phi_m$ stored, or $t_0$ received and $t_m$ stored, calculating the phase difference (called phase angle) between the tested signal and the reference signal.

Measuring step includes steps of filtering, shaping of sinusoidal signals and establishing standard time-base. In step of providing standard time-base, a standard second signal is provided by Global Position Systems (GPS) , and frequency multiplication signal is produced so as to make resolving power of standard time-base signal into 1μs. In addition, the measuring step further includes steps of locking phase and frequency multiplication, and in the calculation step the phase difference is calculated by using counting method. The calculation step also includes steps of predicting of the reference signal and regulating a reference signal according to received reference signal so as to make the difference between the predicting signal and the reference signal into zero.

A measurement system based on the method mentioned above includes

at a reference station, a standard time-base unit for producing the standard time-base signal; at least one filtering and shaping unit; a calculation unit for calculating the phase of the reference signal ($\phi_0$) at a series of given time or the time ($t_0$) at a series of given phase of the reference signal;

at a substation, a standard time-base unit for producing the standard-time base signal; at least one filtering and shaping unit; a calculation unit for calculating the phase of the tested signal ($\phi_m$) at the same given time as to the reference signal or time ($t_m$) of the tested signal at the same given phase as to the reference signal, storing the value, and calculating the phase difference between the phase of the tested signal $\phi_m$ and phase of the reference signal $\phi_0$ or the time difference between $t_m$ and $t_0$;

a communication system for connecting the calculation unit at the reference station with the calculation unit at substations.

The invention provides another electric power system phase angle measuring method and system. The method comprises steps of

a) at a reference station, the shaped reference signal being connected to the receiving terminal of a communication system;

b) sending the shaped reference signal to each substation through the communication system;

c) at a substation, receiving the reference signal, regulating the received signal and outputting the regulated reference signal;

d) measuring the tested signal;

e) calculating the phase angle by comparing the tested signal with the regulated reference signal, wherein in step c) said regulating step including step of compensating the phase delay caused by each parts of the communication system.

A phase angle measuring system based on said method according to the invention includes

at a reference station, a means for sending a shaped reference signal into a communication system;

at a substation, a phase angle measurement means comprising a receiving unit for receiving the reference signal from the communication system, at least one measuring unit for measuring the tested signal at substation, and a calculation unit for calculating the phase difference between the tested signal and the reference signal.

Brief description of drawings

Figure 1 is a diagrammatic sketch of phase angle measurement system for an electric power system.

Figure 2 is a block diagram of a phase angle measurement system using a timing method.

Figure 3 is a detailed block diagram of the standard time-base unit in Fig. 2.

Figure 4 is a detailed block diagram of the filtering and shaping unit in Fig.2 .

Figure 5 is wave form of the phase angle measurement principle of timing method.

Figure 6 is a principle diagram of predicting model adopted by calculation unit (8) in Fig. 2 .

Figure 7 is a block diagram of phase angle measurement system using compensating method.

Detailed description of drawings

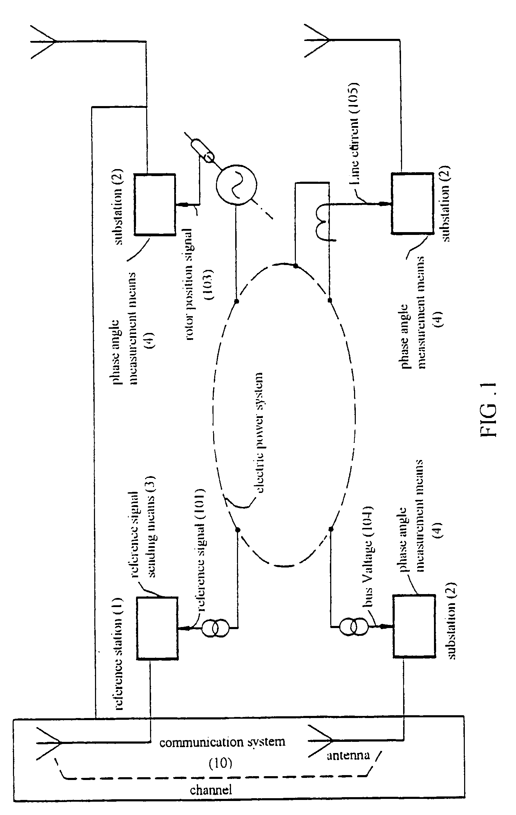

Fig. 1 is the diagrammatic sketch of phase angle measurement system for an electric power systems. Firstly, the reference substation (1) is selected among pivotal substations. At the reference station (1), the reference signal (101) is selected, such as a bus voltage signal from PT, and coupled to input terminals of a sending means (3). The reference signal sending means (3) measures the phase of the reference signal, and then sends it to communication system (10). The communication system (10) delivers the reference signal or phase message to a substation (2) which may be electric substations or power plants, etc. At substation (2), a phase angle measurement unit (4) not only receives the reference signal or phase message sent by communication system (10), but also inputs tested signal (102) of substation (2). In this embodiment, the tested signal may be rotor position signals (103) of generators, or bus voltage signals (104), or current signals (105) through electric lines. The phase difference between tested signal and the reference signal, named phase angle, is calculated by comparing them.

In practical, the phase angle must be phase difference between the tested signal phase and the reference signal phase, which is different from phase difference of two signals on one site or phases of itself. Since a power system is vast in territory, the phase angle measurement has to be completed by means of a communication system. In recent years, for communication technology and systems rapidly developed, in current power systems there are power-line carrier, microwave and optical fiber communication systems, which produces favorable conditions for accomplishing phase angle measurement . However, the communication equipment causes delay of signals, which brings phase delay to power-frequency signals, for example, 6° phase shift per 100 km to a 50Hz signal in spit of the signal traveling on channel at light speed. Now, the area semidiameter of modem large power systems is far over 100 km, and therefore the phase shift at channel is not negligible. The key to be solved in the invention is to overcome phase shift of communication systems.

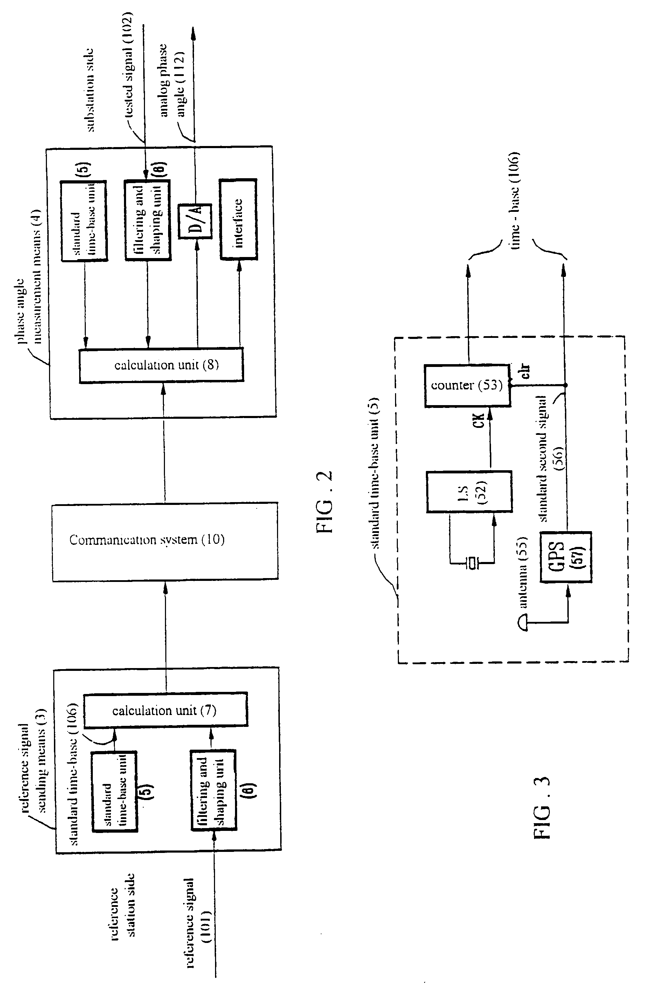

The phase angle measurement system using modem timing and computer technology in Fig.2 overcomes the phase error caused by communication systems. Referring to Fig.2, there is a standard time-base unit (5) in both of the reference signal sending means (3) at the reference station and the phase angle measurement means (4) at substation, which provides a standard time-base signal (106) whose resolving power is micro-second level at precious 1μs. So, though substation (2) may be far from the reference station (1) , the error of the standard time-base signal is within 2μs, and phase angle error caused by time-base error is 0.036° for 50Hz signals. Besides, at least one filtering and shaping unit (6) for filtering and shaping the reference signal (101) and the tested signal (102) is provided in both the reference signal sending means (3) and the phase angle measurement means (4) respectively. The signal sending means (3) and phase measurement means (4) further includes the calculation unit (7) and the calculation unit (8) respectively which measures and computes the signal at each side and calculates the phase angle $\alpha$ by comparing at unit (8).

Referring to Fig.3 ~ Fig.5, the principle and detailed structure of standard time-base unit (5) , the filtering and shaping unit (6) and the calculation unit in Fig.2 are described below.

Firstly, referring to Fig.3, there are many methods to get the standard time-base signal (106), such as crystal oscillating and standard second signal correcting method. An embodiment according to the invention is accomplished by using GPS and computer hardware. GPS receiver (51) receives signals of four satellite of GPS through antenna (55), and solves for three position variables and a time variable by solving four equations, and gives second signal (56) at high accuracy whose error is ±1μs from Universal Standard Time (UTC). The second signal will be connected to clear-zero terminal clr of a counter (53) and to interrupt inputs of calculation unit (7) or calculation unit (8) respectively. The high frequency signal (more than 1MHz) produced by a crystal oscillator (52) is coupled to clock terminal ck of a counter (53), and the output of the counter (53) is coupled to the calculation unit (7) or calculation unit (8). When rise edge of the second signal applies for interruption to calculation unit (7) or calculation unit (8), the computer reads values of the counter (53), the values named M, and at down edge of the second signal (56) the counter (53) will be cleared. As the edges of the pulse of the second signal are very steep (<1μs), M is frequency of the crystal oscillator. Whenever a signal phase is measured, the computer reads out the value m of the counter (53). The ratio of m to M determines the time whose resolving power reaches micro-second level.

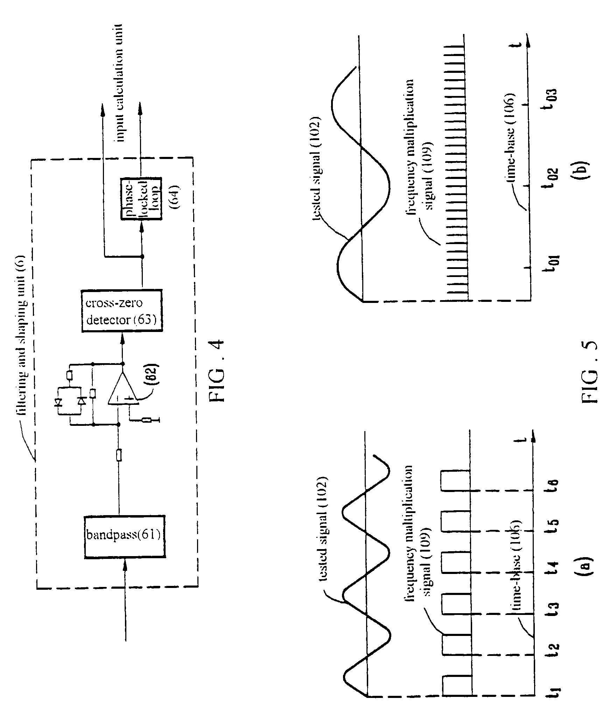

Fig.4 gives an embodiment of the filtering and shaping unit (6). It includes at least one band pass filter (61), variable gain amplifier (62), cross-zero detector (63) and a locked phase loop circuit (64). The band pass filter (61) strains off noise and harmonics disturbance of the tested signal, and outputs a sinusoidal signal. For the sake of precious phase discrimination, the variable gain amplifier (62) is connected in series between the band pass filter (61) and cross-zero detector (63), which will turn the range near zero of sinusoidal signal into steeper so as to benefit cross-zero detecting. The cross zero detector (63) accomplishes phase discrimination and outputs square wave having the same phase as the sinusoidal signal, and the locked phase loop circuit (64) outputs frequency multiplication signal.

There are many methods to measure signal phase based on time-base signal (106), such as cross zero, initial phase at given time, FFT, etc. Since in the method of the cross zero or the initial phase the sampling period is too long ,sometimes up to one cycle, even several cycles of the signal. Therefore, in order to measure several times in one cycle, the invention adopts frequency multiplier and phase locked loop circuit to solve the problem.

The principle of frequency multiplier and phase locked loop circuit for reference signal (101) and tested signal (102) is shown in Fig.5a and Fig.5b. Fig.5a is described for the tested signal (102), but it is available for the reference signal (101). Firstly, frequency multiplication signal (109) (double frequency in the figure as an example ) is produced. Secondly, the time is read at rise edge of signal (109), named t1, t2, t3, t4, ...., which represents a series of given phases (0° and 180° in the figure ). According to Fig.5a, for the reference signal (101), the time read is named $t_{ok}$, k=1, 2, ...; for the tested signal (102), the time read is named $t_{mk}$, k=1, 2, .... Then the kth measurement phase angle between the tested signal (102) and the reference signal (101) is $\alpha_k$:

$$\alpha_k = 360(t_{mk} - t_{ok})/T \qquad (1)$$

where, T is measurement cycle of the reference signal (101). It is thus clear that the phase angle can be measured more times (twice) every cycle according to the method, which is named timing method at given phase .

In Fig.5b, the tested signal (102) is frequency multiplicated and phase locked as signal (109) ( signal (109) is 20 times frequency of signal (102) in the figure, more than 4096 in practice). At rising edge of the tested signal (102), the counter is cleared and then started to count for signal (109). At given time t1, t2,... , (which are agreed in advance or broadcasted by the reference station), the computer in the calculation unit (7) or unit (8) reads values of the counter, which is named $n_{ok}$ for the reference signal and named $n_{mk}$ for the tested signal respectively, k=1, 2, ..... Therefore, the kth phase angle measurement value between the tested signal (102) and the reference signal (101) is

$$\alpha_k = 360(n_{mk} - n_{ok})/N \qquad (2)$$

where, N is multiple of the frequency multiplier ( 20 in the Figure) . Then this method can measure signal phase several times per cycle, named timing method at given time.

Now, let us refer to the operation of the phase angle measurement system in Fig.2. At the reference station (1), firstly, the reference signal (101) is coupled to input of the filtering and shaping unit (6). The signal is filtered and shaped to strain off disturbance, turned into a square wave or sinusoidal signal which has the same phase as the reference signal . Then the signal is coupled to the calculation unit (7). Secondly , the standard time-base signal (106) produced by standard time-base unit (5) is also coupled to the calculation unit (7). Thirdly, in the calculation unit (7), according to the timing method at given phase in Fig.5a or at given time in Fig.5b, by the standard time base signal (106) and the sinusoid or square wave signal, the phase message ($t_{ok}$

or $n_{ok}$) of the reference signal is measured. Finally, the phase message is output to communication system (10). The communication system (10) delivers $t_{ok}$ or $n_{ok}$ to every substation (2).

The calculation unit (8) at substation (2) receives the phase message ($t_{ok}$ to $n_{ok}$) of the reference signal sent by the communication system. On the other hand it inputs shaped signal of the tested signal (102) and the standard time-base signal (106) from standard time-base unit (5) in order to measure the phase message ($t_{mk}$ or $n_{mk}$). The calculation unit (8) calculates the phase angle between the tested signal (102) and the reference signal (101) by formula (1) or (2) .

In accordance with the above illustration , the real time phase angle measurement can be accomplished in principle, but problem is still exist in technology. This is because transmitting the phase message ( $t_{ok}$ or $n_{ok}$) of the reference signal by the communication system needs time, and transmission speeds on channel is 1200 ~ 4800 bps generally, it needs 35 ~ 100 ms to send the phase message, namely 2 ~ 5 cycle, so it is disappointing in real-time. If the communication system has surplus channel, in the method, a data multiplexor can be connected in series between sending means (3) or phase angle measurement means (4) and the communication system (not shown in the figure).

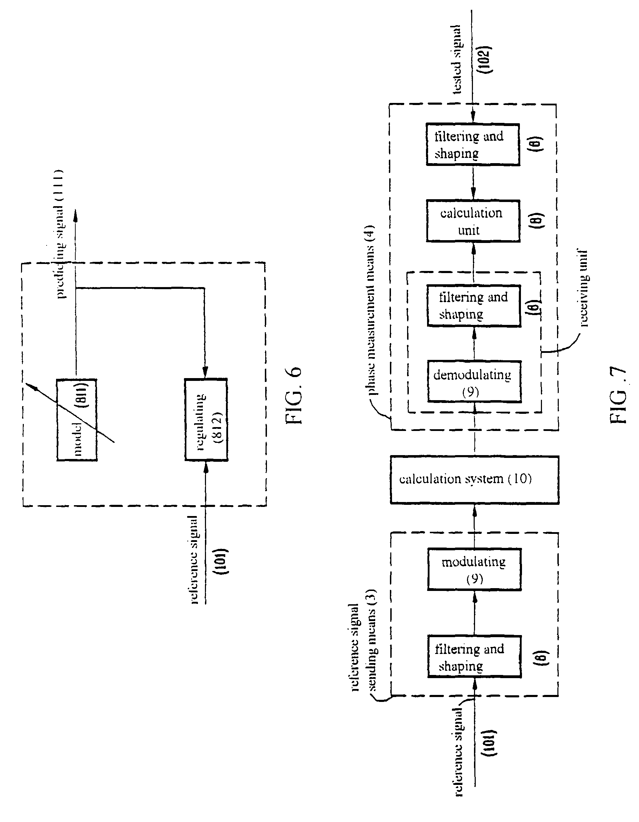

The invention gives another real time measuring method shown in Fig.2 and Fig.6. In the calculation unit (8) of the phase angle measurement means (4) in Fig.2, a predicting modular (81) is added which includes a model modular (811) and a regulating modular (812). The model modular (811) outputs predicting message $\hat{r}$ (111) and its phase message ($\hat{t}_{ok}$ or $\hat{n}_{ok}$). The output phase message ($\hat{t}_{ok}$ or $\hat{n}_{ok}$) of modular (811) is feedback to the regulating modular (812). The regulating modular (812) also inputs the phase message ($t_{ok}$ or $n_{ok}$) of the reference signal (101). The regulating modular (812) outputs signals to change parameters of the model in modular (811) to make error ($t_{ok}$ - $t_{ok}$) or ($n_{ok}$ - $n_{ok}$) close to zero.

The model and regulating modular are designed based on adaptive control theory, or on 2nd order model. Considering the inertia of power systems is very large and change of frequency of the reference signal is slow, though large disturbance caused by tripping generator or dropping load can result in total power increasing or decreasing. So, the phase dynamic equation of the reference signal is 2nd order of uniform acceleration :

$$f = f_0 + a \times t \qquad (3)$$

$$\Phi_0 = \Phi_0 + 360 \times f_0 \times t + 180 \times a \times t^2 \qquad (4)$$

where, **a** is acceleration , undetermined parameter, **t** is time interval, $\hat{f}$ and $\hat{\Phi}_0$, is predicting value of the reference signal. **a** is adjusted by proportion or proportional-integrate to make difference between the predicting output and reference signal close to zero.

So, measuring the phase angle between the tested signal (102) and the reference signal (101) can be accomplished by measuring the phase angle between the tested signal (102) and the predicting signal (111).

Besides the above timing method, the invention also provides a phase compensating method to measure the phase angle shown in Fig.7 .

In Fig.7, at the reference station (1), the reference signal sending means (3), which includes the filtering and shaping unit (6) and modulate-demodulator (9), produces the reference signal and modulates the signal phase on carrier signal by the modulator (9). The carrier signal is delivered to substations (2) by communication systems (10). At the substation (2), the phase angle measurement means (4) includes demodulator (9), filtering and shaping unit (6), calculation unit (8) and another filtering and shaping unit (6). Wherein the demodulator (9) receives the phase of the reference signal sent by the communication system, demodulated signal r' (112) is named as quasi-reference signal. This signal is coupled to the calculation unit (8) after filtered and shaped by the filtering and shaping unit (6). Simultaneously, the calculation unit (8) also receives the tested signal which is filtered and shaped by the other filtering and shaping unit (6). A phase difference β between the tested signal (102) and the quasi-reference signal is calculated in unit (8) according to the clocks of a crystal oscillator. In the communication system there is delay, including sending means delay $\Delta t_1$, receiver delay $\Delta t_2$, relay equipment delay $\Delta t_3$ and channel delay $\Delta t_4$, which results in phase delay of the reference signal, respectively named $\Delta\alpha_1$, $\Delta\alpha_2$, $\Delta\alpha_3$, and $\Delta\alpha_4$. The phase angle α between the tested signal (102) and the reference signal (101) is given as

$$\alpha = \beta + \Delta\alpha_1 + \Delta\alpha_2 + \Delta\alpha_3 + \Delta\alpha_4 \qquad (5)$$

To communication system equipment, when the amplitude of transmitted signal is constant and frequency changes not very much (power-frequency), the phase delay is constant. The phase delay $\Delta\alpha_4$ caused by communication channel can be computed as

$$\Delta\alpha_4 = 0.06 \times L$$

$$(6)$$

where, **L** is the channel length, unit is km. Although formula (6) is for 50Hz signal, for another frequency, it can be inferred by proportion.

The above embodiments and figures are only for understanding the invention. These embodiments can also be alternated to many kinds of forms. Firstly, the phase angle measurement is adapted to the other same frequency signal, such as square wave or pulse signals besides the sinusoid, and is also adapted to harmonies signals. Secondly, the reference signal can be a center pivotal bus voltage signals, or a generator rotor position signal, or combined signals of some center pivotal bus voltage signals and some generator position signals. The above sinusoidal signal is any phase signal among three phase signals, also positive sequence or negative sequence or zero sequence signals, only a positive, or negative, or zero sequence filter need to be connected in series. Lastly, the phase angle output is also regulated by the phase shift produced by transformer of non-12 clock connection between the tested signal and the reference signal, which is traditional knowledge to a person skilled.

Some technicians in the field of the art can do many variations from the invention, but they will fall in the scope of the claims of the invention.

## Claims

1. A method of measuring phase-angle in electric power systems ,comprising steps of :

    a) at a reference station, measuring the relation between the phase of a reference signal and the standard time-base, determining the phase of a reference signal $\phi_0$ at a series of given time with regular intervals, or determining the time $t_0$ at a series of given phases;
    b) sending said phase $\phi_0$ of the reference signal or said time $t_0$ to each substation by communication;
    c) at a substation, measuring the relation between the phase of a tested signal and the standard time-base, determining the phase of the tested signal $\phi_m$ at the same given time with regular intervals as to the reference signal, or determining the time $t_m$ at the same given phase of the tested signal as to the reference signal; and storing said measurement $\phi_m$ or $t_m$;
    d) at the substation, receiving said $\phi_0$ or $t_0$ of the reference signal;
    e) at the substation, in accordance with said $\phi_0$ received and $\phi_m$ stored; or $t_0$ received and $t_m$ stored, calculating the phase difference $\alpha$ ( called phase angle) between the tested signal and the reference signal;

2. A method of measuring phase-angle in electric power systems according to Claim 1, wherein in steps a) and c) further including steps of filtering and shaping the reference signal and the tested signal.

3. A method of measuring phase-angle in electric power systems according to Claim 1, wherein said standard time-base including standard second signals by a Global Position Systems (GPS), and a frequency multiplication time-base, i.e. standard micro-second signals.

4. A method of measuring phase-angle in electric power systems according to Claim 1, wherein in measuring steps a) and step c) further including steps of locking phase and frequency multiplication.

5. A method of measuring phase-angle in electric-power systems according to Claim 1, wherein in calculating step e) further including steps of predicting reference signal according to a predicting model and regulating the predicting model by the difference between the predicting signal and the reference signal.

6. A method of measuring phase-angle in electric power systems according to Claim 5, wherein said predicting model being a quadratic or cubic dynamic equation and said regulating using proportional-integral control.

7. An electric power system phase angle measuring system including communication systems, characterized in that

    at the reference station,
    a standard time-base unit for producing the standard time-base signal of the reference station, which is connected to a calculation unit;
    at least a filtering and shaping unit for filtering the random disturbance among reference signals, which is connected to said calculation unit;
    said calculation unit, which is connected with said communication system, for computing the phase ($\phi_0$) of the reference signal at series of the given time with regular intervals, or time ($t_0$) at a series of the given phase of the reference signal;
    at a substation,
    a standard time-base unit for producing the standard time base signal, which is connected to a calculation unit;
    at least a filtering and shaping unit for filtering random disturbance of a tested signal, which is connected to the calculation unit;
    said calculation unit for calculating phase of the tested signal $\phi_m$ at the given time or time of the tested signal $t_m$ at the given phase , storing said values $\phi_m$ or $t_m$ , receiving $\phi_0$ or $t_0$ of the reference signal sent by communication, and calculating the phase angle between the tested signal and the reference signal according to $\phi_m$ and $\phi_0$ or $t_m$ and $t_0$;
    the calculation unit at the reference station is connected to the calculation unit at substations by the communication system.

8. An electric power system phase angle measuring system including communication systems according to Claim 7 ,wherein said filtering and shaping unit at least includes a band pass filtering and shaping circuit.

9. An electric power system phase angle measuring system including communication systems according to Claim 7, wherein said standard time-base unit includes a standard clock signal generator, a frequency multiplication means and a counter.

10. An electric power system phase angle measuring system including communication systems according to Claim 9 , wherein the standard clock signal generator includes a receiver of Global Position System (GPS) and the frequency multiplication means includes a crystal oscillator.

11. An electric power system phase angle measuring system including communication systems according to Claim 7, wherein a data multiplexor is connected between the communication system and the calculation unit.

12. An electric power system phase angle measuring system including communication systems according to Claim 7, wherein the calculation unit at substation includes a predicting model and a regulating model for predicting the reference signal.

13. An electric power system phase angle measuring method comprises steps of

    a) at a reference station, a shaped reference signal being input into a receiving terminal of a communication system;
    b) sending said shaped reference signal to each substation through the communication system;
    c) at a substation, receiving said reference signal from commutation system and compensating phase;
    d) at the substation, measuring the phase of a tested signal ;
    e) at the substation, calculating the phase angle between the reference signal compensated and the tested signal .

14. An electric power system phase angle measuring method according to Claim 13, wherein in the compensating step a phase delay is produced from sending means, receiving means, relaying units and communication channels.

15. An electric power system phase measuring system comprises

    at a reference station, a means for shaping a reference signal and sending the shaped reference signal to a communication system;
    at a substation, a phase angle measurement means including a receiving unit for receiving the reference signal from the communication system and compensating the phase delay of the received signal, at least one measuring unit for measuring the phase of the tested signal and the phase of the compensated reference signal and a calculation unit for calculating the phase angle between the tested signal and the reference signal.

16. An electric power system phase measuring system according to Claim 15, wherein said means for sending reference signal includes a band pass filter, a shaping circuit and a modulator.

17. An electric power system phase measuring system according to Claim 15, wherein said receiving unit includes a demodulator, a filtering and shaping circuit and a calculation unit in which the received signal phase is compensated.

FIG. 1

FIG . 2

FIG . 3

FIG . 4

bandpass(61) — filtering and shaping unit (6) — (62) — cross-zero detector (63) — phase-locked loop (64) — input calculation unit

FIG . 5

(a) tested signal (102), frequency multiplication signal (109), time-base (106), $t_1$ $t_2$ $t_3$ $t_4$ $t_5$ $t_6$

(b) tested signal (102), frequency multiplication signal (109), time-base (106), $t_{01}$ $t_{02}$ $t_{03}$

predicting signal (111)

model (811)

regulating (812)

reference signal (101)

## FIG. 6

tested signal (102)

filtering and shaping (8)

calculation unit (8)

filtering and shaping (8)

demodulating (9)

phase measurement means (4)

receiving unit

calculation system (10)

modulating (9)

filtering and shaping (8)

reference signal sending means (3)

reference signal (101)

## FIG.7

## INTERNATIONAL SEARCH REPORT

| | International application No. |
|---|---|
| | PCT/CN 95/00092 |

**A. CLASSIFICATION OF SUBJECT MATTER**

IPC⁶ G01R 25/00, 25/08, G04F 5/00, G04G 7/02

According to International Patent Classification (IPC) or to both national classification and IPC

**B. FIELDS SEARCHED**

Minimum documentation searched (classification system followed by classification symbols)

IPC⁶ G01R 25/00, 25/08, G04F 5/00, G04G 7/02

Documentation searched other than minimum documentation to the extent that such documents are included in the fields searched

Chinese Patent Documents(1985~)

Electronic data base consulted during the international search (name of data base and, where practicable, search terms used)

**C. DOCUMENTENTS CONSIDERED TO BE RELEVANT**

| Category* | Citation of document, with indication, where appropriate, of the relevant passages | Relevant to claim No. |
|---|---|---|
| A | CN2119666U(XU YUN)21.10.1992, page 1~2 | 1.2.4.7.8.13.15 |
| A | CN 2133847Y(CHONG QING, SHIZHONG District, SHU GUANG MASHINE-ELECTRICITY, TECHNOLOGY INSTITODE 19.05.1993 page 1, line 17~25 | 1.2.7.8.13.15.17 |
| E | CN 1112247A(HYUNDAI ELECTRONICS INDUSTRIES CO. , LTD KOREA)22.11.95 page 1~page 2 line 1 | 1.3.7.10.13.15 |
| A | EP0564220A2(GLENARY ELECTRONICS, INC.) 06.10.1993, Column 3, line 21~Column 4, line 54 | 1.3.7.13 |

[ ] Further documents are listed in the continuation of Box C.  [X] See patent family annex.

\* Special categories of cited documents:
"A" document defining the general state of the art which is not considered to be of particular relevance
"E" earlier document but published on or after the international filing date
"L" document which may throw doubts on priority claims(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 31. Jaunary 1996(31.01.96) | 2 2 FEB 1996  (22.02.96) |

| Name and mailing address of the ISA. | Authorized officer |
|---|---|
| Chinese Patent Office, 6 Xitucheng Rd. Jimen Bridge. Haidian District. 100088 Beijing. China | WANG ZHI SEN |
| Facsimile No.  (86—010)2019451 | Telephone No. (86—010)2093915 |